# EUROPÄISCHE PATENTSCHRIFT

(11) **EP 2 345 095 B1**
(45) Veröffentlichungstag und Bekanntmachung des Hinweises auf die Patenterteilung: **04.09.2013**
(21) Anmeldenummer: 09752805.3
(22) Anmeldetag: 11.11.2009
(51) Int. Cl.: H01L 41/047, H01L 41/22

(54) **Piezoaktor in Vielschichtbauweise und Verfahren zur Befestigung einer Aussenelektrode bei einem Piezoaktor**
Piezoelectric actuator of multilayer design and method for fastening an outer electrode in a piezoelectric actuator
Actionneur piézoélectrique de construction multicouche et procédé de fixation d'une électrode extérieure sur un actionneur piézoélectrique

(30) Priorität: 11.11.2008 DE 102008056746
(43) Veröffentlichungstag der Anmeldung: 20.07.2011
(73) Patentinhaber: Epcos AG, 81669 München (DE)
(72) Erfinder: RINNER, Franz, A-8530 Deutschlandsberg (AT); SOMITSCH,Dieter, A-8522 Groß St. Florian (AT); RESZAT, Jan-Thorsten, A-8530 Deutschlandsberg (AT); GABL, Reinhard, A-8542 St. Peter (AT); GALLER, Martin, A-8020 Graz (AT); AUER, Christoph, A-8043 Graz (AT); KÜGERL, Georg, A-8552 Eibiswald (AT)
(74) Vertreter: Epping - Hermann - Fischer
(86) Internationale Anmeldenummer: PCT/EP2009/065009
(87) Internationale Veröffentlichungsnummer: WO 2010/055071

(56) Entgegenhaltungen:
- EP-A- 1 780 813
- EP-A- 2 043 170
- EP-A2- 1 814 169
- DE-A1- 10 225 408
- US-A1- 2002 084 350

## Beschreibung

Es wird ein Piezoaktor in Vielschichtbauweise angegeben, bei dem piezoelektrische Schichten und Elektrodenschichten zu einem Stapel angeordnet sind. Zur elektrischen Kontaktierung der Elektrodenschichten sind Außenelektroden an Außenseiten des Stapels befestigt. Derartige Piezoaktoren werden beispielsweise zur Betätigung eines Einspritzventils in einem Kraftfahrzeug eingesetzt.

In den Druckschriften EP 0844678 B1 und EP 2043170 A2 ist ein Piezoaktor mit einer am Stapel befestigten Außenelektrode beschrieben.

Es ist eine zu lösende Aufgabe, eine Außenelektrode möglichst beschädigungsfrei mit dem Stapel aus piezoelektrischen Schichten und Elektrodenschichten zu verbinden.

Es wird ein Piezoaktor in Vielschichtbauweise mit einem Stapel aus piezoelektrischen Schichten und dazwischen angeordneten Elektrodenschichten angegeben. Der Piezoaktor weist mindestens eine Außenelektrode auf, die mittels einer durch thermisches Spritzen aufgebrachten Schicht an einer Außenseite des Stapels befestigt ist.

Vorzugsweise sind alle Schichten des Stapels gemeinsam gesintert und bilden einen monolithischen Vielschichtaktor. Für die piezoelektrischen Schichten werden beispielsweise dünne Folien, die ein piezoelektrisches Materials wie Blei-Zirkonat-Titanat (PZT) enthalten, verwendet. Zur Bildung der Elektrodenschichten kann in einem Siebdruckverfahren eine Metallpaste, zum Beispiel eine Silber-Palladium-Paste oder auch eine kupferhaltige Paste, auf die Folien aufgebracht werden. Die Folien werden anschließend z. B. entlang einer Längsachse gestapelt, verpresst und gemeinsam gesintert. Dabei muss nicht auf jede piezoelektrische Schicht eine Elektrodenschicht aufgebracht sein. Beispielsweise können sich zwischen zwei Elektrodenschichten mehrere piezoelektrische Schichten befinden.

Die piezoelektrischen Schichten werden polarisiert, so dass sie sich beim Anlegen einer Spannung zwischen benachbarte Elektrodenschichten entlang ihrer Polarisationsrichtung ausdehnen. Zur elektrischen Kontaktierung der Elektrodenschichten werden diese mit Außenelektroden verbunden. Beispielsweise sind zwei Außenelektroden auf zwei Außenseiten des Stapels angebracht. Die Elektrodenschichten können dann entlang der Stapelrichtung abwechselnd bis zu einer der Außenelektroden geführt und mit dieser elektrisch verbunden sein und gegenüber der zweiten Außenelektrode zurückversetzt sein. Auf diese Weise können die Elektrodenschichten einer Polarität über eine gemeinsame Außenelektrode elektrisch kontaktiert werden.

Zur sicheren elektrischen Kontaktierung muss die Außenelektrode zuverlässig an der Außenseite des Stapels befestigt sein. Die Außenelektrode ist mittels einer durch thermisches Spritzen aufgebrachten Haftschicht am Stapel befestigt.

Diese Befestigungsart hat den Vorteil, dass bei der Befestigung der Außenelektrode am Stapel die Piezokeramik nicht so stark erhitzt wird, dass Beschädigungen am Stapel auftreten. Zwar können an der Außenseite des Stapels lokal höhere Temperaturen, beispielsweise im Bereich von 100 °C bis 200 °C auftreten, jedoch betrifft die Temperaturerhöhung nicht das gesamte Volumen des Stapels und tritt nur kurzzeitig auf. Zudem liegt die durch thermisches Spritzen aufgebrachte Haftschicht vorzugsweise eng an der Außenelektrode und am Stapel an und weist eine geringe Dicke auf. Dies ermöglicht eine besonders platzsparende Kontaktierung des Piezoaktors.

Die Haftschicht haftet zumindest teilweise an der Außenelektrode und am Piezostapel und befestigt somit die Außenelektrode am Stapel. Die Haftschicht haftet zumindest teilweise an der Oberseite der Außenelektrode und der Außenseite des Stapels.

Die Oberseite der Außenelektrode ist dabei diejenige Seite der Außenelektrode, die bei einer auf dem Stapel aufgelegten Außenelektrode direkt von außen zugänglich ist. Darunter fallen die von außen gut sichtbaren Bereiche der Außenelektrode, die parallel zur Außenseite des Stapels angeordnet sind. Es fallen jedoch auch Bereiche der Außenelektrode unter den Begriff "Oberseite", die direkt von außen zugänglich sind, aber weniger gut von außen einsehbar sind, da sie gegenüber der Außenseite des Stapels geneigt sind. Dies sind z. B. Bereiche am äußeren Rand der Außenelektrode oder Bereiche der Außenelektrode, die Löcher in der Außenelektrode begrenzen. Beispielsweise bedeckt die Haftschicht die Oberseite der Außenelektrode.

Entsprechend dazu haftet die Haftschicht zumindest teilweise an den Bereichen der Außenseite des Stapels, die von außen bei aufgelegter Außenelektrode direkt zugänglich sind, d. h. nicht von der Außenelektrode verdeckt sind. Dies sind z. B. Bereiche der Außenseite des Stapels, die um die Außenelektrode herum angeordnet sind, oder Bereiche, die durch Aussparungen in der Außenelektrode hindurch von außen einsehbar sind.

Vorzugsweise erstreckt sich die Haftschicht nicht in einen Bereich zwischen der Außenseite des Stapels und der Außenelektrode, der nicht direkt von außen zugänglich ist. Dies betrifft beispielsweise Bereiche, in der die Außenelektrode die Außenseite des Stapels bedeckt und somit nach außen hin abschattet. Somit ist die Außenelektrode in diesen Bereichen nicht fest mit dem Stapel verbunden. Dies hat den Vorteil, dass auftretende Risse an der Außenseite des Stapels von der Außenelektrode überbrückt werden können und sich nicht in die Außenelektrode fortsetzen. Vorzugsweise liegt die Außenelektrode jedoch zumindest teilweise direkt an der Außenseite des Stapels an und ist auch in elektrischem Kontakt mit der Außenseite des Stapels. In diesem Fall ist es möglich, die Elektrodenschichten direkt über die Außenelektrode zu kontaktieren. Eine Kontaktierung der Elektrodenschichten ist somit auch bei einer gering oder nicht elektrisch leitfähigen Haftschicht möglich.

Die Bereiche der Außenelektrode und des Stapels, die mit der Haftschicht in direktem mechanischen Kontakt stehen, werden im Wesentlichen durch das verwendete thermische Spritzverfahren bestimmt. Dabei wird zuerst ein Stapel aus piezoelektrischen Schichten und dazwischen angeordneten Elektrodenschichten bereitgestellt und eine Außenelektrode auf eine Außenseite des Stapels aufgelegt. Anschließend wird ein Material auf das Bauteil thermisch aufgespritzt. Hier sind vorzugsweise nur die Teilbereiche der Außenelektrode und des Stapels von der Haftschicht bedeckt, die direkt von außen, d. h. von der Einspritzrichtung aus, für die Spritzpartikel zugänglich sind.

In einer Ausführungsform ist an der Außenseite des Stapels eine Kontaktschicht zur elektrischen Kontaktierung der Elektrodenschichten angeordnet. Die Außenelektrode ist an dieser Kontaktschicht befestigt. Vorzugsweise liegt die Außenelektrode zumindest teilweise direkt auf der Kontaktschicht auf.

Beispielsweise ist die Kontaktschicht eine Grundmetallisierung, die beim Sintern des Stapels mit eingebrannt wird. Sie kann aus dem gleichen Material wie die Elektrodenschichten bestehen, zum Beispiel aus einer Silber-Palladium-Paste oder einer kupferhaltigen Paste. Die Kontaktschicht ist dabei im Bereich einer sogenannten inaktiven Zone an der Außenseite des Stapels befestigt, in der entlang der Stapelrichtung jede zweite Elektrodenschicht auf die Außenseite des Stapels herausgeführt ist und mit der Kontaktschicht in elektrischem Kontakt steht. Beispielsweise sind auf zwei gegenüberliegenden Seiten des Stapels Kontaktschichten im Bereich von inaktiven Zonen angeordnet.

Vorzugsweise ist die Haftschicht elektrisch leitfähig.

Dies hat den Vorteil, dass die elektrische Kontaktierung der Elektrodenschichten auch über die Haftschicht und nicht nur über die Außenelektrode ermöglicht wird. Somit ist auch eine elektrische Kontaktierung der Elektrodenschichten gewährleistet, wenn die Haftschicht in den Bereich zwischen der Außenelektrode und dem Stapel hineinreicht und mit der Kontaktschicht oder den Elektrodenschichten in elektrischem Kontakt steht. Zudem kann die Spannungsversorgung der Elektrodenschichten auch durch eine an der Haftschicht befestigte Weiterkontaktierung erfolgen. Beispielsweise wird dazu eine Zuleitung in Form eines Drahtes, auf die Haftschicht aufgelötet.

Beispielsweise enthält die Haftschicht ein Metall.

Des Metall ist vorzugsweise so gewählt, dass die Haftschicht gut auf einer Grundmetallisierung und einer metallischen Außenelektrode haftet und eine zuverlässige elektrische Anbindung herstellen kann. Beispielsweise enthält die Haftschicht das gleiche Metall wie die Grundmetallisierung oder wie die Außenelektrode. Das Metall der Haftschicht ist beispielsweise aus der Menge Kupfer, Silber, Aluminium und Zinn gewählt.

In einer Ausführungsform ist die Außenelektrode ein Drahtgewebe, das Löcher aufweist.

Das Drahtgewebe ist beispielsweise ein Stahldrahtgewebe, ein Kupferdrahtgewebe oder ein Gewebe aus einer Eisen-Nickel-Legierung. Die Drähte können auch mit Kupfer beschichtet sein, wodurch die Lötbarkeit der Außenelektrode verbessert werden kann. Beispielsweise kann somit ein elektrischer Anschluss zum Anlegen einer elektrischen Spannung besonders gut auf die Außenelektrode aufgelötet werden.

Das Drahtgewebe kann auch mehrlagig ausgeführt sein. In diesem Fall ist die Wahrscheinlichkeit für ein vollständiges Durchreißen der Außenelektrode vermindert, so dass die elektrische Kontaktierung besonders zuverlässig ist.

In einer weiteren Ausführungsform ist die Außenelektrode als ein mit Löchern versehenes Blech ausgebildet.

Beispielsweise enthält das Blech Stahl, Kupfer oder eine Eisen-Nickel-Legierung. Die Löcher können durch Ausstanzen in das Blech eingebracht werden.

Derartige, Löcher aufweisende Außenelektroden können besonders gut am Stapel befestigt werden. Beim thermischen Spritzen wird die Haftschicht von außen auf die Oberseite der Außenelektrode und den Stapel aufgebracht. Die Außenelektrode ist dabei besonders zuverlässig am Stapel befestigt, wenn die Haftschicht gleichzeitig auf möglichst vielen Bereichen der Außenelektrode und des Stapels haftet. Vorzugsweise sind möglichst viele Stellen, an denen die Haftschicht am Stapel haftet, eng benachbart zu Stellen, an denen die Haftschicht an der Außenelektrode haftet.

Vorzugsweise sind die Löcher gleichmäßig über die Außenelektrode verteilt, so dass die Außenelektrode an möglichst vielen Stellen mit dem Stapel verbunden werden kann.

Vorzugsweise sind die Löcher mit der Haftschicht gefüllt.

Beispielsweise ist die Außenseite des Stapels im Bereich der Löcher von der Haftschicht bedeckt. Dabei muss die Haftschicht die Löcher nicht unbedingt vollständig füllen. Es reicht aus, wenn die Löcher teilweise von der Haftschicht gefüllt sind.

Weiterhin wird ein Verfahren zur Befestigung einer Außenelektrode bei einem Piezoaktor angegeben. Dabei wird zuerst ein Stapel aus piezoelektrischen Schichten und dazwischen angeordneten Elektrodenschichten bereitgestellt. Anschließend wird auf eine Außenseite des Stapels eine Außenelektrode aufgelegt. Danach wird ein Material auf Teile der Oberseite der Außenelektrode und Teile der Außenseite des Stapels aufgetragen. Vorzugsweise wird das Material thermisch aufgespritzt und dabei in Partikelform gebracht.

Vorzugsweise ist der Stapel aus piezoelektrischen Schichten und dazwischen angeordneten Elektrodenschichten gesintert, bevor die Außenelektrode auf die Außenseite aufgelegt wird. Beispielsweise ist eine Kontaktschicht auf der Außenseite des Stapels mit eingesintert, auf die die Außenelektrode aufgelegt wird.

Das Material wird so aufgespritzt, dass die Außenelektrode mit dem Stapel fest verbunden wird. Das thermisch aufgespritzte Material bildet eine Haftschicht, die zumindest teilweise auf der Oberseite der Außenelektrode und auf der Außenseite des Stapels haftet.

Beispielsweise wird beim thermischen Aufspritzen ein Verfahren, ausgewählt aus der Menge Flammspritzen, Plasmaspritzen, Kaltgasspritzen und Lichtbogenspritzen verwendet.

Bei diesen Verfahren wird das Material in Partikelform gebracht, beschleunigt, und auf die Oberfläche der Außenelektrode und des Piezostapels geschleudert. Beim Auftreffen auf die Bauteiloberfläche können sich die Spritzpartikel mechanisch verformen und bleiben an der Oberfläche haften. Die Verfahren unterscheiden sich dabei vor allem in der Temperatur und der Geschwindigkeit der Partikel. So wird beispielsweise beim Flammspritzen das Material durch Erwärmung an- oder aufgeschmolzen, in Partikelform gebracht und auf die Oberfläche des Bauteils geschleudert. Beim Kaltgasspritzen wird pulverförmiges Material verwendet, das nur leicht erwärmt wird, und mit hoher Geschwindigkeit auf die zu beschichtende Oberfläche geschleudert wird. Beim Auftreffen auf der Oberfläche verbinden sich die Partikel untereinander und mit der Oberfläche aufgrund der entstehenden Reibungswärme. Die thermischen Spritzverfahren haben den Vorteil, dass der Stapel während des Aufspritzvorgangs nicht oder nur geringfügig erwärmt werden muss und somit keine oder nur geringe thermische Beschädigungen am Stapel verursacht werden.

Vorzugsweise liegt die Temperatur des Stapels während des thermischen Aufspritzens unter der Schmelztemperatur des Materials, das die Haftschicht bildet.

Beispielsweise beträgt die Temperatur des Stapels weniger als 200 °C.

Dabei ist auch mit eingeschlossen, dass an der Außenseite des Stapels kurzzeitig und lokal höhere Temperaturen herrschen. Diese Temperaturen betreffen jedoch nicht das gesamte Volumen des Stapels und auch nicht die gesamte Außenseite des Stapels.

Im Folgenden werden der angegebene Piezoaktor und seine vorteilhaften Ausgestaltungen anhand von schematischen und nicht maßstabsgetreuen Figuren erläutert. Es zeigen:
Figur 1 eine Aufsicht auf einen Piezoaktor mit einer Außenelektrode und einer Haftschicht,
Figur 2 einen Querschnitt eines Piezoaktors mit einer Außenelektrode und einer Haftschicht gemäß Figur 1,
Figuren 3A bis 3D ein Verfahren zur Befestigung einer Außenelektrode bei einem Piezoaktor.

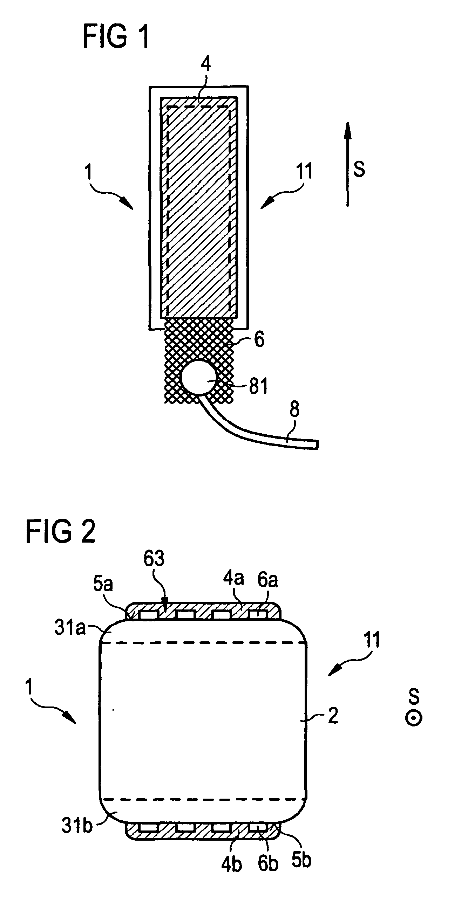

Figur 1 zeigt einen Piezoaktor 1 mit einem Stapel 11 aus piezoelektrischen Schichten (hier nicht dargestellt) und Elektrodenschichten (hier nicht dargestellt), die entlang einer Stapelrichtung S, die der Längsachse des Stapels 11 entspricht, übereinander angeordnet sind. Die piezoelektrischen Schichten und die dazwischen liegenden Elektrodenschichten sind gemeinsam gesintert und bilden einen monolithischen Sinterkörper. Zur Kontaktierung der Elektrodenschichten sind auf zwei gegenüberliegenden Seitenflächen Außenelektroden 6 angebracht. In Figur 1 ist die Aufsicht auf eine Seitenfläche dargestellt, an der eine Außenelektrode 6 befestigt ist. Auf der Außenseite des Stapels 11 ist eine als Grundmetallisierung ausgeführte Kontaktschicht aufgebracht (hier nicht zu sehen), um eine bessere elektrische Kontaktierung der Elektrodenschichten und eine zuverlässigere Anbindung der Außenelektrode 6 zu ermöglichen.

Die Außenelektrode 6 ist als Drahtgewebe ausgeführt und mittels einer durch thermisches Spritzen aufgebrachten Haftschicht 4 am Stapel 11 befestigt. Die Außenelektrode 6 ist von der Haftschicht 4 bedeckt. In Figur 1 ist der Umriss der Außenelektrode 6 unter der Haftschicht 4 deshalb nur gestrichelt eingezeichnet. Die Haftschicht 4 haftet an der Oberseite der Außenelektrode 6, das heißt an der Seite der Außenelektrode 6, die vom Stapel 11 abgewandt ist. Dies umfasst auch seitliche Bereiche der Außenelektrode 6. Zudem haftet die Haftschicht 4 auch an Bereichen der Kontaktschicht. In diesem Ausführungsbeispiel ist die Außenelektrode 6 über den Stapel 11 hinaus verlängert und mit einer Zuleitung 8 zur Spannungsversorgung verbunden. Die Zuleitung 8 ist durch eine Lötung 81 an der Außenelektrode 6 befestigt. Die Anbindung der Zuleitung 8 kann zum Beispiel auch durch Schweißen erfolgen. Die Außenelektrode 6 muss nicht über den Stapel 11 hinausreichen, sondern kann auch vollständig von der Haftschicht 4 bedeckt sein. In diesem Fall kann eine Zuleitung 8 auch direkt an der Haftschicht 4 befestigt sein.

Figur 2 zeigt einen Querschnitt des Piezoaktors 1 aus Figur 1. Es ist eine Aufsicht auf eine piezoelektrische Schicht 2 zu sehen. Der Stapel 11 aus piezoelektrischen Schichten und Elektrodenschichten weist zwei gegenüber liegende inaktive Zonen 31a, 31b auf. Innerhalb der inaktiven Zonen 31a, 31b tritt in Stapelrichtung S keine Überlappung von benachbarten gegenpoligen Elektrodenschichten auf, da die Elektrodenschichten abwechselnd bis an die Außenseite des Piezoaktors hingeführt und in Bezug auf die gegenüberliegende Außenseite zurückversetzt sind. Auf die Außenseiten des Stapels sind Kontaktschichten 5a, 5b aufgebracht und darauf Außenelektroden 6a, 6b befestigt. Die Außenelektroden 6a, 6b liegen direkt auf den Kontaktschichten 5a, 5b auf. Die Elektrodenschichten werden abwechselnd von einer der auf die Außenseite des Piezoaktors 1 aufgebrachten Außenelektroden 6a, 6b elektrisch kontaktiert.

Die Außenelektroden 6a, 6b sind als Drahtgewebe ausgeführt, bei denen metallische Drähte miteinander verwoben sind. Zwischen den Drähten befinden sich Löcher 63 in der Außenelektrode 6a, 6b. Die Haftschicht 4a, 4b haftet auf Teilen der Oberseite der Außenelektrode 6a, 6b und Teilen der Außenseite des Stapels 11 und reicht auch in die Löcher 63 der Außenelektrode 6a, 6b hinein. Somit haftet die Haftschicht 4a, 4b im Bereich der Löcher 63 und um die Außenelektrode 6a, 6b herum an der Kontaktschicht 5a, 5b auf der Außenseite des Stapels 11. Die Haftschicht 4a, 4b haftet zudem an der Oberseite der Außenelektrode 6a, 6b, insbesondere auch an seitlichen Bereichen der Drähte der Außenelektrode 6a, 6b. Diese seitlichen Bereiche sind z. B. die Bereiche, die die Löcher 63 der Außenelektrode 6 umgeben, sowie Randbereiche der Außenelektrode 6a, 6b. Hingegen reicht die Haftschicht 4a, 4b nicht unter die Außenelektrode 6a, 6b, d. h. es befindet sich keine Haftschicht 4a, 4b direkt zwischen der Außenseite des Stapels 11 und der Außenelektrode 6a, 6b.

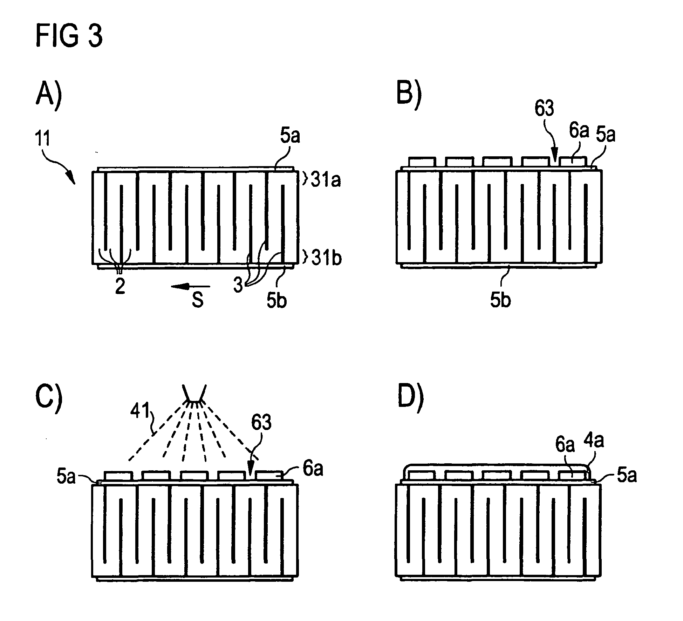

In den Figuren 3A bis 3D ist in Schnittbildern schematisch das Verfahren zur Befestigung einer Außenelektrode 6a bei einem Piezoaktor 1 dargestellt. In Schritt A) wird ein Stapel 11 aus piezoelektrischen Schichten 2 und dazwischen angeordneten Elektrodenschichten 3 bereitgestellt. Die piezoelektrischen Schichten 2 sind beispielsweise piezokeramische Schichten. Es ist dabei nicht notwendig, dass zwischen allen piezoelektrischen Schichten.2 Elektrodeschichten 3 angeordnet sind. Die Elektrodenschichten 3 sind entlang der Stapelrichtung S abwechselnd bis auf eine Außenseite des Stapels 11 herausgeführt und gegenüber der anderen Außenseite zurückversetzt. Auf diese Weise werden inaktive Zonen 31a, 31b gebildet, in denen sich in Stapelrichtung S benachbarte Elektrodenschichten 3 unterschiedlicher Polarität nicht überlappen. Der dargestellte Stapel 11 ist gesintert und weist Kontaktschichten 5a, 5b auf, die ebenfalls durch Sintern mit dem Stapel 11 verbunden sind.

Im Schritt B) wird eine Außenelektrode 6a auf eine Kontaktschicht 5a an der Außenseite des Stapels 11 aufgelegt. Die Außenelektrode 6a ist ein mit Löchern 63 versehenes Drahtgewebe oder Metallblech.

In Schritt C) wird ein metallisches Material 41 auf Teile der Oberseite der Außenelektrode 6a und Teile der Außenseite der Kontaktschicht 5a aufgespritzt. Das Material 41 liegt dabei in Partikelform vor. Es trifft mit hoher Geschwindigkeit auf die Kontaktschicht 5a und die Außenelektrode 6a auf, so dass sich beim Aufprall die Partikel verbinden und eine Haftschicht 4a bilden. Das Material 41 dringt auch in die Löcher 63 der Außenelektrode 6a ein.

Während des Aufspritzvorgangs kann die Temperatur des Materials 41 oberhalb der Schmelztemperatur des Materials 41 liegen. Es ist jedoch auch möglich, dass die Temperatur des Materials 41 unterhalb der Schmelztemperatur liegt und dass sich die Partikel des Materials 41 beim Aufprall auf das Bauteil aufgrund der entstehenden Reibungswärme untereinander und mit dem Bauteil verbinden.

In Figur 3D) ist der Zustand am Ende des Aufspritzvorgangs dargestellt. Die Außenelektrode 6a ist von einer Haftschicht 4a bedeckt, wobei diese Haftschicht 4a auch in die Löcher 63 der Außenelektrode hineinreicht. Innerhalb dieser Löcher 63 und um die Außenelektrode 6a herum ist die Haftschicht in direktem mechanischen Kontakt mit der Kontaktschicht 5a. Ansonsten ist die Haftschicht 4a in direktem Kontakt mit der Oberseite der Außenelektrode 6a.

Um auf die gegenüberliegende Außenseite des Stapels 11 ebenfalls eine Außenelektrode 6b aufzubringen, wird der Stapel 11 umgedreht und es werden die Schritte A) bis C) des Verfahrens erneut durchgeführt.

Die Erfindung ist nicht durch die Beschreibung an Hand der Ausführungsbeispiele auf diese beschränkt, sondern umfasst jede Kombination von Merkmalen in den Patentansprüchen.

### Bezugszeichenliste

- 1: Piezoaktor
- 11: Stapel
- 2: piezoelektrische Schicht
- 3: Elektrodenschicht
- 31a, 31b: inaktive Zone
- 4, 4a, 4b: Haftschicht
- 41: Material
- 5a, 5b: Kontaktschicht
- 6, 6a, 6b: Außenelektrode
- 63: Löcher
- 8: Zuleitung
- 81: Lötung

## Patentansprüche

1. Piezoaktor in Vielschichtbauweise
- mit einem Stapel (11) aus piezoelektrischen Schichten (2) und dazwischen angeordneten Elektrodenschichten (3)
- und mit mindestens einer Außenelektrode (6, 6a, 6b), die mittels einer durch thermisches Spritzen aufgebrachten Haftschicht (4, 4a, 4b) an einer Außenseite des Stapels (11) befestigt ist und
- bei dem die Haftschicht (4, 4a, 4b) zumindest teilweise an der Oberseite der Außenelektrode (6, 6a, 6b) und der Außenseite des Stapels (11) haftet.

2. Piezoaktor nach Anspruch 1,
- bei dem an der Außenseite des Stapels (11) eine Kontaktschicht (5a, 5b) zur elektrischen Kontaktierung der Elektrodenschichten (3) angeordnet ist und
- bei dem die Außenelektrode (6, 6a, 6b) an der Kontaktschicht (5a, 5b) befestigt ist.

3. Piezoaktor nach Anspruch 2,
- bei dem die Haftschicht an Bereichen der Kontaktschicht (5a, 5b) haftet.

4. Piezoaktor nach einem der Ansprüche 1 bis 3,
- bei dem die Haftschicht (4, 4a, 4b) elektrisch leitfähig ist.

5. Piezoaktor nach Anspruch 4,
- bei dem die Haftschicht (4, 4a, 4b) ein Metall enthält.

6. Piezoaktor nach Anspruch 5,
- bei dem das Metall aus der Menge Kupfer, Silber, Aluminium und Zinn gewählt ist.

7. Piezoaktor nach einem der Ansprüche 1 bis 6,
- bei dem die Außenelektrode (6, 6a, 6b) als ein Löcher (63) aufweisendes Drahtgewebe (61) ausgebildet ist.

8. Piezoaktor nach einem der Ansprüche 1 bis 6,
- bei dem die Außenelektrode (6, 6a, 6b) als ein mit Löchern (63) versehenes Blech ausgebildet ist.

9. Piezoaktor nach einem der Ansprüche 7 oder 8,
- bei dem die Löcher (63) mit der Haftschicht (4, 4a, 4b) gefüllt sind.

10. Piezoaktor nach einem der Ansprüche 1 bis 9,
- bei dem die Außenelektrode (6, 6a, 6b) wenigstens ein Material aus der Menge Kupfer, Stahl und Eisen-Nickel-Legierung enthält.

11. Piezoaktor nach einem der Ansprüche 1 bis 10,
- der durch gemeinsame Sinterung aller Schichten (2, 3) des Stapels (11) hergestellt ist.

12. Verfahren zur Befestigung einer Außenelektrode bei einem Piezoaktor, umfassend die Schritte:
A) Bereitstellen eines Stapels (11) aus piezoelektrischen Schichten (2) und dazwischen angeordneten Elektrodenschichten (3),
B) Auflegen einer Außenelektrode (6, 6a, 6b) auf eine Außenseite des Stapels (11),
C) Thermisches Aufspritzen eines Materials (41) auf Teile der Oberseite der Außenelektrode (6, 6a, 6b) und der Außenseite des Stapels (11).

13. Verfahren nach Anspruch 12,
- wobei beim thermischen Aufspritzen in Schritt C) ein Verfahren ausgewählt aus der Menge Flammspritzen, Plasmaspritzen, Kaltgasspritzen und Lichtbogenspritzen verwendet wird.

14. Verfahren nach einem der Ansprüche 12 bis 13,
- wobei die Temperatur des Stapels (11) während des thermischen Aufspritzens in Schritt C) unter der Schmelztemperatur des Materials (41) liegt.

15. Verfahren nach Anspruch 14,
- wobei die Temperatur des Stapels (11) weniger als 200 °C beträgt.

## Claims

1. Piezoelectric actuator of a multilayer design
- with a stack (11) of piezoelectric layers (2) and electrode layers (3) arranged in between
- and with at least one outer electrode (6, 6a, 6b), which is fastened to an outer side of the stack (11) by means of a bonding layer (4, 4a, 4b) applied by thermal spraying, and
- in which the bonding layer (4, 4a, 4b) bonds at least partially to the upper side of the outer electrode (6, 6a, 6b) and the outer side of the stack (11).

2. Piezoelectric actuator according to Claim 1,
- in which a contact layer (5a, 5b) for the electrical contacting of the electrode layers (3) is arranged on the outer side of the stack (11) and
- in which the outer electrode (6, 6a, 6b) is fastened to the contact layer (5a, 5b).

3. Piezoelectric actuator according to Claim 2,
- in which the bonding layer bonds to regions of the contact layer (5a, 5b).

4. Piezoelectric actuator according to one of Claims 1 to 3,
- in which the bonding layer (4, 4a, 4b) is electrically conductive.

5. Piezoelectric actuator according to Claim 4,
- in which the bonding layer (4, 4a, 4b) contains a metal.

6. Piezoelectric actuator according to Claim 5,
- in which the metal is chosen from the group comprising copper, silver, aluminum and tin.

7. Piezoelectric actuator according to one of Claims 1 to 6,
- in which the outer electrode (6, 6a, 6b) is formed as a woven wire fabric (61) having holes (63).

8. Piezoelectric actuator according to one of Claims 1 to 6,
- in which the outer electrode (6, 6a, 6b) is formed as a metal sheet provided with holes (63).

9. Piezoelectric actuator according to either of Claims 7 and 8,
- in which the holes (63) are filled with the bonding layer (4, 4a, 4b).

10. Piezoelectric actuator according to one of Claims 1 to 9,
- in which the outer electrode (6, 6a, 6b) contains at least one material from the group comprising copper, steel and iron-nickel alloy.

11. Piezoelectric actuator according to one of Claims 1 to 10,
- which is produced by sintering all the layers (2, 3) of the stack (11) at one and the same time.

12. Method for fastening an outer electrode in a piezoelectric actuator, comprising the steps of:
A) providing a stack (11) of piezoelectric layers (2) and electrode layers (3) arranged in between,
B) placing an outer electrode (6, 6a, 6b) onto an outer side of the stack (11),
C) thermally spraying a material (41) onto parts of the upper side of the outer electrode (6, 6a, 6b) and the outer side of the stack (11).

13. Method according to Claim 12,
- a method chosen from the group comprising flame spraying, plasma spraying, cold-gas spraying and arc spraying being used for the thermal spraying-on in step C).

14. Method according to either of Claims 12 and 13,
- the temperature of the stack (11) during the thermal spraying-on in step C) lying below the melting temperature of the material (41).

15. Method according to claim 14,
- the temperature of the stack (11) being less than 200°C.

## Revendications

1. Actionneur piézoélectrique de construction multicouche :
- doté d'une pile (11) composée de couches piézoélectriques (2) et de couches d'électrode (3) intercalées ; et
- doté d'au moins une électrode extérieure (6, 6a, 6b) fixée à un côté extérieur de la pile (11) à l'aide d'une couche d'adhérence (4, 4a, 4b) appliquée par injection thermique ; et
- dans lequel la couche d'adhérence (4, 4a, 4b) adhère au moins en partie au côté supérieur de l'électrode extérieure (6, 6a, 6b) et du côté extérieur de la pile (11).

2. Actionneur piézoélectrique selon la revendication 1 :
- dans lequel une couche de contact (5a, 5b) est disposée au niveau du côté extérieur de la pile (11) afin de mettre en contact électrique les couches d'électrode (3) ; et
- dans lequel l'électrode extérieure (6, 6a, 6b) est fixée à la couche de contact (5a, 5b).

3. Actionneur piézoélectrique selon la revendication 2, dans lequel la couche d'adhérence adhère aux régions de la couche de contact (5a, 5b).

4. Actionneur piézoélectrique selon l'une quelconque des revendications 1 à 3, dans lequel la couche d'adhérence (4, 4a, 4b) est électriquement conductrice.

5. Actionneur piézoélectrique selon la revendication 4, dans lequel la couche d'adhérence (4, 4a, 4b) contient un métal.

6. Actionneur piézoélectrique selon la revendication 5, dans lequel le métal est sélectionné parmi l'ensemble comprenant le cuivre, l'argent, l'aluminium et le zinc.

7. Actionneur piézoélectrique selon l'une quelconque des revendications 1 à 6, dans lequel l'électrode extérieure (6, 6a, 6b) prend la forme d'une toile métallique (61) comportant des trous (63).

8. Actionneur piézoélectrique selon l'une quelconque des revendications 1 à 6, dans lequel l'électrode extérieure (6, 6a, 6b) prend la forme d'une tôle pourvue de trous (63).

9. Actionneur piézoélectrique selon l'une quelconque des revendications 7 ou 8, dans lequel les trous (63) sont remplis de la couche d'adhérence (4, 4a, 4b).

10. Actionneur piézoélectrique selon l'une quelconque des revendications 1 à 9, dans lequel l'électrode extérieure (6, 6a, 6b) contient au moins un matériau parmi l'ensemble comprenant le cuivre, l'acier et un alliage fer-nickel.

11. Actionneur piézoélectrique selon l'une quelconque des revendications 1 à 10, fabriqué par frittage commun de toutes les couches (2, 3) de la pile (11).

12. Procédé de fixation d'une électrode extérieure sur un actionneur piézoélectrique, comprenant les étapes suivantes :
A) mise à disposition d'une pile (11) composée de couches piézoélectriques (2) et de couches d'électrode (3) intercalées ;
B) application d'une électrode extérieure (6, 6a, 6b) sur un côté extérieur de la pile (11) ;
C) injection thermique d'un matériau (41) sur des parties du côté supérieur de l'électrode extérieure (6, 6a, 6b) et du côté extérieur de la pile (11).

13. Procédé selon la revendication 12, dans lequel l'injection thermique réalisée à l'étape C) utilise un procédé sélectionné parmi l'ensemble comprenant l'injection au flammage, l'injection au plasma, l'injection au gaz froid et l'injection à l'arc électrique.

14. Procédé selon l'une quelconque des revendications 12 à 13, la température de la pile (11) se situant en dessous de la température de fusion du matériau (41) pendant l'injection thermique réalisée à l'étape C).

15. Procédé selon la revendication 14, la température de la pile (11) étant inférieure à 200 °C.
